# EUROPÄISCHE PATENTSCHRIFT

(11) **EP 3 314 276 B1**
(45) Veröffentlichungstag und Bekanntmachung des Hinweises auf die Patenterteilung: **26.05.2021**
(21) Anmeldenummer: 16731095.2
(22) Anmeldetag: 16.06.2016
(51) Int. Cl.: G01R 19/14, G01R 31/36, G01R 31/392, G01R 31/396

(54) **MESSANORDNUNG ZUM ERKENNEN EINER FEHLFUNKTION EINER ENERGIESPEICHERANORDNUNG**
MEASURING ARRANGEMENT FOR IDENTIFYING A MALFUNCTION OF AN ENERGY ACCUMULATOR ASSEMBLY
SYSTÈME DE MESURE PERMETTANT DE DÉTECTER UN DYSFONCTIONNEMENT D'UN SYSTÈME ACCUMULATEUR D'ÉNERGIE

(30) Priorität: 24.06.2015 DE 102015110185
(43) Veröffentlichungstag der Anmeldung: 02.05.2018
(73) Patentinhaber: Phoenix Contact GmbH & Co. KG, 32825 Blomberg (DE)
(72) Erfinder: NEUMANN, Daniel, 33039 Nieheim (DE); MANTLER, Eugen, 32839 Steinheim (DE)
(74) Vertreter: Patentship Patentanwaltsgesellschaft mbH
(86) Internationale Anmeldenummer: PCT/EP2016/063861
(87) Internationale Veröffentlichungsnummer: WO 2016/207052

(56) Entgegenhaltungen:
- EP-A2- 0 982 830
- EP-A2- 1 203 964
- DE-T2- 60 202 485
- US-A1- 2012 182 021

## Beschreibung

Die vorliegende Erfindung betrifft eine Messanordnung zur Überwachung von Energiespeichern einer Energiespeicheranordnung und zur Identifizierung von fehlerhaften Energiespeichern der Energiespeicheranordnung.

Energiespeicheranordnungen, welche aus mehreren elektrisch verbundenen Energiespeichern bestehen, werden beispielsweise in unterbrechungsfreien Stromversorgungen (USV) eingesetzt. Die Aufgabe einer USV ist es, elektrische Anlagen, welche an ein Stromnetz angeschlossen sind, vor Störungen in dem Stromnetz zu schützen. Im Falle eines Ausfalls oder einer Schwankung des Netzstroms können die Energiespeicher der USV innerhalb weniger Millisekunden die Stromversorgung der elektrischen Anlage übernehmen. Bei den Energiespeichern der USV handelt es sich häufig um Akkumulatoren, beispielsweise um Lithium-Polymer-Akkumulatoren. Diese Energiespeicher sind meist parallel verschaltet um einen gemeinsamen Energiespeicher mit hoher Ladekapazität zu bilden.

Während der Lebenszeit einer USV sind die Energiespeicher einem Alterungsprozess ausgesetzt, beispielsweise aufgrund der Belastung durch regelmäßige Auf- und Entladevorgänge, oder aufgrund von Temperaturschwankungen. Dies kann zu frühzeitigen Defekten einzelner Energiespeicher der Energiespeicheranordnung führen. Defekte in einzelnen Energiespeichern können die Sicherheit des USV-Systems verringern und im Extremfall zu einem kompletten Ausfall des USV-Systems führen. Die meist parallele Verschaltung erschwert die Auswertung der einzelnen Energiespeicher, so dass ein einzelner fehlerhafter Energiespeicher in der Energiespeicheranordnung schwer zu identifizieren ist.

Aus den Druckschriften US 2012 / 182021 A1, DE60202485 T2 und EP 0 982 830 A2 sind weitere Energiespeicheranordnungen mit parallel verschalteten Energiespeichern bekannt.

Es ist die der Erfindung zugrundeliegende Aufgabe, eine Messanordnung zur Überwachung von Energiespeichern einer Energiespeicheranordnung und zur Identifizierung von fehlerhaften Energiespeichern der Energiespeicheranordnung zu schaffen.

Diese Aufgabe wird durch Gegenstände mit den Merkmalen nach den unabhängigen Ansprüchen gelöst. Vorteilhafte Ausführungsformen der Erfindung sind Gegenstand der Figuren, der Beschreibung und der abhängigen Ansprüche.

Gemäß einem ersten Aspekt der Erfindung wird die Aufgabe durch eine Messanordnung zum Erkennen einer Fehlfunktion einer Energiespeicheranordnung mit einem ersten Energiespeicher und mit zumindest einem weiteren Energiespeicher gelöst, wobei der erste Energiespeicher und der weitere Energiespeicher elektrisch parallel geschaltet sind, mit: einer Messeinrichtung, welche ausgebildet ist, eine Polarität einer elektrischen Messgröße des ersten Energiespeichers und eine Polarität einer weiteren elektrischen Messgröße in der Energiespeicheranordnung zu erfassen; einer Prozessoreinrichtung, welche ausgebildet ist, die Fehlfunktion der Energiespeicheranordnung durch einen Vergleich der Polarität der elektrischen Messgröße des ersten Energiespeichers und der Polarität der weiteren elektrischen Messgröße zu erkennen. Dadurch wird der Vorteil erreicht, dass eine Fehlfunktion eines Energiespeichers der Energiespeicheranordnung im laufenden Betrieb und ohne eine Einschränkung der Nutzung der Energiespeicheranordnung erfasst werden kann.

Die Messanordnung kann als abgeschlossenes Modul vorliegen, welches beispielsweise ein Gehäuse umfasst, in dem alle Komponenten der Messanordnung angeordnet sind. Dieses Modul kann elektrische Anschlüsse für eine externe Energiespeicheranordnung vorsehen. Ferner kann die Messanordnung zusammen mit der Energiespeicheranordnung ein abgeschlossenes Bauteil bilden, in welchem beispielsweise die Komponenten der Messanordnung und die Energiespeicher in einem gemeinsamen Gehäuse angeordnet sind.

Bei den Energiespeichern kann es sich um Akkumulatoren, beispielsweise Lithium-Ionen-Akkumulatoren, Lithium-Polymer-Akkumulatoren oder Bleiakkumulatoren, handeln, welche eine Akkumulator-Spannung von beispielsweise 12 oder 24 Volt aufweisen können. Dabei können die Energiespeicher, die in der Energiespeicheranordnung miteinander elektrisch verbunden sind, gleichen Typs sein und eine gleiche Spannung und eine gleiche Säuredichte aufweisen.

Die Prozessoreinrichtung kann ein Mikrocontroller sein, wobei der Mikrocontroller einen Prozessor und/oder einen Speicher umfassen kann. Die Prozessoreinrichtung kann mit der Messeinrichtung zum Empfang der gemessenen elektrischen Messgrößen elektrisch verbunden sein. Ferner kann die Prozessoreinrichtung derart konfiguriert sein, dass sie Parameterwerte aus den empfangenen elektrischen Messgrößen berechnet.

In einer vorteilhaften Ausführungsform der Messanordnung ist die Prozessoreinrichtung ausgebildet, die Fehlfunktion der Energiespeicheranordnung zu erkennen, falls die Polarität der elektrischen Messgröße des ersten Energiespeichers und die und die Polarität der weiteren elektrischen Messgröße unterschiedlich sind. Dadurch wird der Vorteil erreicht, dass eine effiziente Identifizierung eines fehlerhaften Energiespeichers erfolgen kann.

In einer weiteren vorteilhaften Ausführungsform der Messanordnung ist die Messeinrichtung ausgebildet, die Polarität der elektrischen Messgröße des ersten Energiespeichers und die Polarität der weiteren elektrischen Messgröße durch Erfassung einer elektrischen Richtung der elektrischen Messgröße des ersten Energiespeichers und der weiteren elektrischen Messgröße zu erfassen. Dadurch wird der Vorteil erreicht, dass eine effiziente Erfassung der Polaritäten der gemessenen elektrischen Messgrößen erfolgen kann.

In einer weiteren vorteilhaften Ausführungsform der Messanordnung ist die weitere elektrische Messgröße eine elektrische Messgröße des weiteren Energiespeichers, oder ist die weitere elektrische Messgröße eine elektrische Messgröße an einem Verbindungspunkt des ersten Energiespeichers und des weiteren Energiespeichers. Dadurch wird der Vorteil erreicht, dass die Polarität der elektrischen Messgrößen einzelner Energiespeichers der Energiespeicheranordnung und die Polarität gemeinsamer elektrischer Messgrößen mehrerer Energiespeicher der Energiespeicheranordnung zur Identifizierung eines fehlerhaften Energiespeichers genutzt werden können.

In einer weiteren vorteilhaften Ausführungsform der Messanordnung weist die Messanordnung eine erste Messeinheit zur Erfassung der Polarität der elektrischen Messgröße des ersten Energiespeichers und eine weitere Messeinheit zur Erfassung der Polarität der weiteren elektrischen Messgröße auf. Dadurch wird der Vorteil erreicht, dass die Polarität der elektrischen Messgröße eines jeden Energiespeichers der Energiespeicheranordnung effizient erfasst werden kann.

In einer weiteren vorteilhaften Ausführungsform der Messanordnung ist die erste Messeinheit ausgebildet, die Polarität der elektrischen Messgröße des ersten Energiespeichers zu erfassen, und ist die weitere Messeinheit ausgebildet, die Polarität der elektrischen Messgröße des weiteren Energiespeichers zu erfassen, oder ist die weitere Messeinheit ausgebildet ist, die Polarität der weiteren elektrischen Messgröße an einem Verbindungspunkt des ersten Energiespeichers und des weiteren Energiespeichers zu erfassen. Dadurch wird der Vorteil erreicht, dass die Polarität der elektrischen Messgrößen einzelner Energiespeichers der Energiespeicheranordnung und die Polarität gemeinsamer elektrischer Messgrößen mehrerer Energiespeicher der Energiespeicheranordnung effizient erfasst werden können.

In einer weiteren vorteilhaften Ausführungsform der Messanordnung ist die weitere Messeinheit ausgebildet, die Polarität der elektrischen Messgröße des weiteren Energiespeichers zu erfassen, wobei die Messeinrichtung eine gemeinsame Messeinheit zur Erfassung der Polarität der elektrischen Messgröße an dem Verbindungspunkt des ersten Energiespeichers und des weiteren Energiespeichers aufweist, um eine gemeinsame Polarität zu erhalten, und wobei die Prozessoreinrichtung ausgebildet ist, die Fehlfunktion der Energiespeicheranordnung durch einen Vergleich der Polarität der elektrischen Messgröße des ersten Energiespeichers oder der Polarität der weiteren elektrischen Messgröße mit der gemeinsamen Polarität zu erkennen. Dadurch wird der Vorteil erreicht, dass eine effiziente Identifizierung der fehlerhaften Energiespeicher in der Energiespeicheranordnung erfolgen kann.

Erfindungsgemäß weist die Messanrdnung eine Schaltungsanordnung mit einem ersten steuerbaren Schalter zum elektrischen Verbinden des ersten Energiespeichers mit der Messeinrichtung und mit einem weiteren steuerbaren Schalter zum elektrischen Verbinden des weiteren Energiespeichers mit der Messeinrichtung auf, um den ersten Energiespeicher und den weiteren Energiespeicher parallel zu schalten, wobei die Prozessoreinrichtung ausgebildet ist, zur Erfassung der Polarität der elektrischen Messgröße des ersten Energiespeichers und zur Erfassung der Polarität der weiteren elektrischen Messgröße den ersten Schalter und den weiteren Schalter zu schließen oder geschlossen zu halten. Dadurch wird der Vorteil erreicht, dass die Energiespeicher während der Erfassung der Polaritäten der Messeinrichtung zur Verfügung stehen.

Die steuerbaren Schalter der Schaltungsanordnung können Transistorschalter, insbesondere MOSFET-Schalter, sein. Insbesondere kann jeder steuerbare Schalter aus einer elektrischen Schaltung bestehen, welche zwei in Reihe geschaltete MOSFET-Schalter umfasst, deren Source-Anschlüsse elektrisch verbunden sind. Zusätzlich kann zur Spannungsbegrenzung eine Zener-Diode zwischen die Source- und die Gate-Anschlüsse der MOSFET-Schalter geschalten werden.

In einer weiteren vorteilhaften Ausführungsform der Messanordnung ist die Prozessoreinrichtung ausgebildet, zur Erfassung der ersten elektrischen Messgröße des ersten elektrischen Energiespeichers den ersten Schalter geschlossen zu halten und den weiteren Schalter zu öffnen, um den weiteren elektrischen Energiespeicher von der Messeinrichtung abzutrennen, und zur Erfassung der weiteren elektrischen Messgröße des weiteren elektrischen Energiespeichers den weiteren Schalter geschlossen zu halten und den ersten Schalter zu öffnen, um den ersten Energiespeicher von der Messeinrichtung abzutrennen, und wobei die Messeinrichtung ausgebildet ist, die erste elektrische Messgröße und die weitere elektrische Messgröße nacheinander zu messen. Dadurch wird der Vorteil erreicht, dass mit der Messanordnung die elektrische Messgröße eines jeden Energiespeichers der Energiespeicheranordnung effizient und unbeeinflusst von den anderen Energiespeichern der Energiespeicheranordnung erfasst werden kann.

Handelt es sich bei den steuerbaren Schaltern um Transistorschalter, so kann die Prozessoreinrichtung zur Steuerung der steuerbaren Schalter mit den Gate-Elektroden der Transistorschalter elektrisch verbunden sein und diese durch das Anlegen einer Gate-Spannung elektrisch steuern. Um bei der Ansteuerung der Gate-Elektroden der Transistorschalter eine ausreichend hohen Gate-Spannung bereitzustellen können Gleichspannungswandler, beispielsweise Hochsetzsteller oder Ladungspumpen, zwischen die Prozessoreinrichtung und die Gate-Elektroden der Transistorschalter geschaltet sein.

In einer weiteren vorteilhaften Ausführungsform der Messanordnung ist die Prozessoreinrichtung ausgebildet, die erste elektrische Messgröße und die weitere elektrische Messgröße bei erkannter Fehlfunktion eines Energiespeichers der Energiespeicheranordnung zu erfassen. Dadurch wird der Vorteil erreicht, dass eine gezielte Prüfung der einzelnen Energiespeicher durchgeführt werden kann um einen Fehlerhaften Energiespeicher eindeutig zu identifizieren.

In einer weiteren vorteilhaften Ausführungsform der Messanordnung ist die Messeinrichtung ausgebildet, die elektrischen Messgröße des ersten Energiespeichers und die elektrische Messgröße des weiteren Energiespeichers in zeitlich aufeinanderfolgenden Messintervallen zu erfassen, wobei innerhalb eines Messintervalls genau nur ein Schalter der Schaltungsanordnung geschlossen ist und alle anderen Schalter der Schaltungsanordnung geöffnet sind. Dadurch wird der Vorteil erreicht, dass die Messung einer elektrischen Messgröße eines Energiespeichers effizient und unbeeinflusst von den anderen Energiespeichern der Energiespeicheranordnung erfolgen kann.

In einer weiteren vorteilhaften Ausführungsform der Messanordnung ist die Prozessoreinrichtung ausgebildet, innerhalb eines ersten Messintervalls nur den ersten Schalter geschlossen zu halten und den weiteren Schalter zu öffnen, und innerhalb eines weiteren Messintervalls nur den weiteren Schalter geschlossen zu halten und den ersten Schalter zu öffnen. Dadurch wird der Vorteil erreicht, dass die Erfassung der elektrischen Messgröße eines jeden Energiespeichers der Energiespeicheranordnung unbeeinflusst von weiteren Energiespeichern der Energiespeicheranordnung erfolgen kann.

Erfindungsgemäß ist die Prozessoreinrichtung ausgebildet, die gemessenen elektrischen Messgrößen auszuwerten, insbesondere mit elektrischen Referenzgrößen zu vergleichen, um eine Fehlfunktion des ersten Energiespeichers oder des weiteren Energiespeichers zu erfassen. Dadurch wird der Vorteil erreicht, dass einzelne defekte Energiespeicher in der Energiespeicheranordnung effizient identifiziert werden können.

In einer weiteren vorteilhaften Ausführungsform der Messanordnung ist die Prozessoreinrichtung ausgebildet, bei erfasster Fehlfunktion des ersten Energiespeichers den ersten steuerbaren Schalter dauerhaft zu öffnen, um den ersten Energiespeicher abzutrennen, oder bei erfasster Fehlfunktion des weiteren Energiespeichers den weiteren steuerbaren Schalter dauerhaft zu öffnen, um den weiteren Energiespeicher abzutrennen. Dadurch wird der Vorteil erreicht, dass eine negative Beeinflussung der Energiespeicheranordnung durch einen fehlerhaften Energiespeicher verhindert werden kann.

In einer weiteren vorteilhaften Ausführungsform der Messanordnung weist die Messanordnung einen Verbindungsanschluss zum Verbinden der Schaltungsanordnung mit einer Hilfsenergieversorgungsvorrichtung, insbesondere einer unterbrechungsfreien Spannungsversorgung auf, um die elektrischen Energiespeicher für die Hilfsenergieversorgung bereitzustellen. Dadurch wird der Vorteil erreicht, dass eine Hilfsenergieversorgungsvorrichtung mit hoher Zuverlässigkeit geschaffen werden kann.

In einer weiteren vorteilhaften Ausführungsform der Messanordnung umfasst die Hilfsenergieversorgungsvorrichtung eine Ladefunktion und/oder einen externen Lader zum elektrischen Laden der Energiespeicher.

In einer weiteren vorteilhaften Ausführungsform der Messanordnung umfasst die Messanordnung den ersten Energiespeicher und den weiteren Energiespeicher. Dadurch wird der Vorteil erreicht, dass eine erweiterte Energiespeicheranordnung geschaffen werden kann, welche die in ihr integrierten Energiespeicher überwachen und fehlerhafte Energiespeicher identifizieren kann.

In einer weiteren vorteilhaften Ausführungsform der Messanordnung weist die Messanordnung eine Kommunikationsschnittstelle, insbesondere eine LIN-Bus-Schnittstelle, zum Ausgeben von elektrischen Messgrößen und/oder Parametern oder zum Empfang von Parametern und/oder Steuerbefehlen auf. Damit wird der Vorteil erreicht, dass eine effiziente Kommunikation zwischen der Messanordnung und einer an die Messanordnung angeschlossenen Vorrichtung erfolgen kann. Bei der Vorrichtung kann es sich beispielsweise um eine Hilfsenergieversorgungsvorrichtung handeln.

Die Kommunikationsschnittstelle kann mit einer Kommunikationsleitung in der Messeinrichtung verbunden sein. Ferner können die Prozessoreinrichtung und/oder die Messeinheiten der Messeinrichtung und/oder die Energiespeicher der Energiespeicheranordnung an die Kommunikationsleitung angeschlossen sein. Auf diese Art und Weise können über die Kommunikationsleitung die von der Prozessoreinrichtung erfassten Messgrößen an die an die Kommunikationsschnittstelle angeschlossene Vorrichtung übermittelt werden, oder Steuerbefehle, beispielsweise Befehle zum Öffnen oder Schließen der steuerbaren Schalter, von der an die Kommunikationsschnittstelle angeschlossenen Vorrichtung an die Prozessoreinrichtung übermittelt werden. Zudem können Betriebsparameter der Energiespeicher über die Kommunikationsleitung an die Prozessoreinrichtung oder an die an die Kommunikationsschnittstelle angeschlossene Vorrichtung übermittelt werden.

Gemäß einem zweiten Aspekt der Erfindung wird die Aufgabe durch eine Hilfsenergieversorgungsvorrichtung zur netzunabhängigen Bereitstellung elektrischer Energie gelöst, wobei die erfindungsgemäße Messanordnung in der Hilfsenergieversorgungsvorrichtung integriert ist. Dadurch wird der Vorteil erreicht, dass eine Hilfsenergieversorgungsvorrichtung mit hoher Zuverlässigkeit geschaffen werden kann, welche ohne extern angeschlossene Energiespeicher genutzt werden kann.

Ausführungsbeispiele der Erfindung sind in den Zeichnungen dargestellt und werden im Folgenden näher beschrieben.

Es zeigen:
- Fig. 1a: eine schematische Darstellung der Polaritäten der elektrischen Messgrößen mehrerer Energiespeicher;
- Fig. 1b: eine schematische Darstellung der Polaritäten der elektrischen Messgrößen mehrerer Energiespeicher;
- Fig. 2: eine schematische Darstellung einer Parallelschaltung zweier Energiespeicher;
- Fig. 3: eine schematische Darstellung einer Messanordnung;
- Fig. 4: eine schematische Darstellung einer Schaltungsanordnung; und
- Fig. 5: eine schematische Darstellung einer Messanordnung.

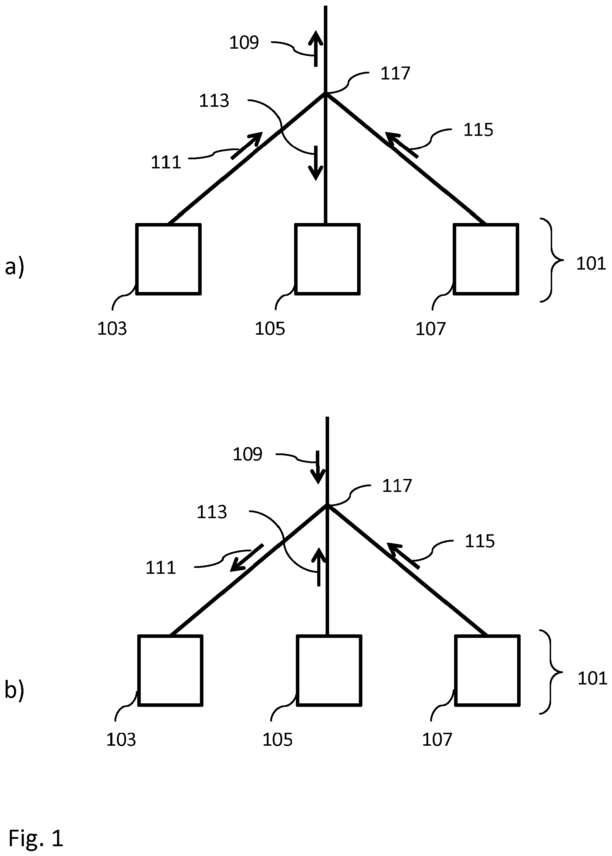

Fig. 1a und Fig. 1b zeigen schematische Darstellungen der Polaritäten von elektrischen Messgrößen in einer Energiespeicheranordnung 101, bestehend aus einem ersten Energiespeicher 103 und zwei weiteren Energiespeichern 105, 107, welche an einem Verbindungspunkt 117 elektrisch verbunden sind.

Bei den Energiespeichern kann es sich um Akkumulatoren, beispielsweise Lithium-Ionen-Akkumulatoren, Lithium-Polymer-Akkumulatoren oder Bleiakkumulatoren, handeln, welche eine Akkumulator-Spannung von beispielsweise 12 oder 24 Volt aufweisen können. Dabei können die Energiespeicher, die in der Energiespeicheranordnung 101 miteinander elektrisch verbunden sind, gleichen Typs sein und eine gleiche Spannung und eine gleiche Säuredichte aufweisen.

Die elektrische Messgröße bezieht sich in Fig. 1a und Fig.1b auf den Lade- oder Entladestrom des ersten Energiespeichers 103, die Lade- oder Entladeströme der weiteren Energiespeicher 105, 107 sowie den gemeinsamen Lade- oder Entladestrom der Energiespeicheranordnung 101. Die Pfeile in Fig. 1a und Fig. 1b markieren die Stromrichtung 111 des Lade- oder Entladestroms des ersten Energiespeichers 103, die Stromrichtungen 113, 115 der Lade- oder Entladeströme der weiteren Energiespeicher 105, 107 sowie die gemeinsame Stromrichtung 109 der Lade- oder Entladeströme der Energiespeicheranordnung 101.

In Fig. 1a zeigen die gemeinsame Stromrichtung 109 der Energiespeicheranordnung 101, die Stromrichtung 111 des ersten Energiespeichers 103 und die Stromrichtung 115 eines weiteren Energiespeichers 107 in Entladerichtung. Die Stromrichtung 113 eines zusätzlichen weiteren Energiespeichers 105 zeigt jedoch in Laderichtung. Diese Abweichung kann auf einen Defekt des weiteren Energiespeichers 105 hinweisen. Der fehlerhafte weitere Energiespeicher 105 in Fig. 1a wird nicht entladen und bezieht stattdessen einen Ladestrom, welcher von dem ersten Energiespeicher 103 und/oder dem anderen weiteren Energiespeicher 107 bezogen wird. In dieser Anordnung kann der fehlerhafte weitere Energiereicher 105 über die Messung der Polaritäten des Lade- oder Entladestroms des ersten Energiespeichers 103, der Polaritäten der Lade- oder Entladeströme der weiteren Energiespeicher 105, 107, sowie der Polarität des gemeinsamen Lade- oder Entladestroms der Energiespeicheranordnung 101 identifiziert werden.

In Fig. 1b zeigt die gemeinsame Stromrichtung 109 der Energiespeicheranordnung 101, sowie die Stromrichtung 111 des ersten Energiespeichers 103 in Laderichtung. Die Stromrichtung 113, 115 der weiteren Energiespeicher 105, 107 zeigen jedoch in Entladerichtung. Diese Abweichung kann auf einen Defekt des ersten Energiespeichers 103 hinweisen. Die weiteren Energiespeicher 105, 107 in Fig. 1b werden entladen und stellen dem ersten Energiespeicher 103 einen zusätzlichen Ladestrom zur Verfügung. Dies kann durch eine Fehlfunktion des ersten Energiespeichers 103 verursacht sein, welcher aufgrund eines Defektes einen zusätzlichen Ladestrom von den weiteren Energiespeicher 105, 107 bezieht. In dieser Anordnung kann der fehlerhafte erste Energiereicher 103 über die Messung der Polaritäten des Lade- oder Entladestroms des ersten Energiespeichers 103, der Polaritäten der Lade- oder Entladeströme der weiteren Energiespeicher 105, 107, sowie der Polarität des gemeinsamen Lade- oder Entladestroms der Energiespeicher identifiziert werden.

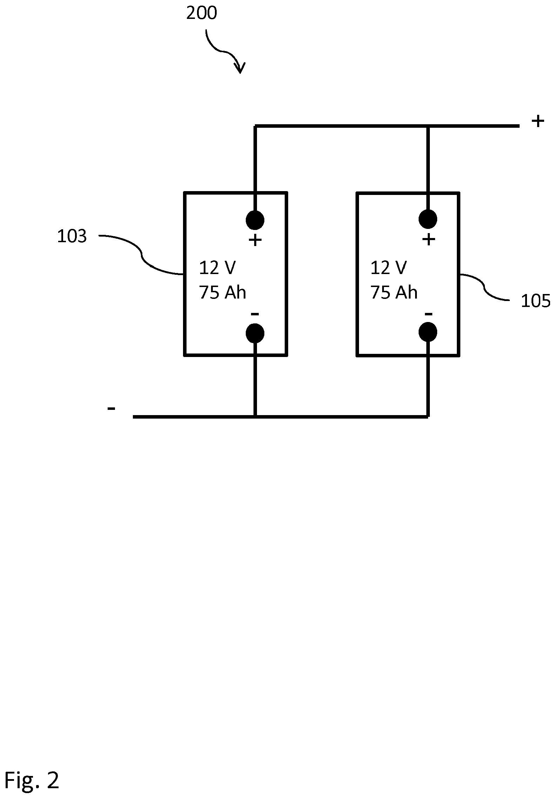

Fig. 2 zeigt eine schematische Darstellung einer Parallelschaltung 200 eines ersten Energiespeichers 103 und eines weiteren Energiespeichers 105.

Die Parallelschaltung 200 des ersten Energiespeichers 103 und des weiteren Energiespeichers 105 kann gebildet werden, indem die die Pluspole der Energiespeicher und die Minuspole der Energiespeicher miteinander elektrisch verbunden werden. Gemäß einer weiteren Ausführungsform kann es sich bei dem so verbundenen Energiespeichern um Energiespeicher des gleichen Typs, beispielsweise Akkumulatoren mit gleicher Spannung und gleicher Säuredichte, handeln.

In Fig. 2 weisen beispielsweise der erste Energiespeicher 103 und der weitere Energiespeicher 105 eine Spannung von jeweils 12 V und eine Ladekapazität von jeweils 75 Ah auf. Durch die Parallelschaltung 200 summiert sich die Ladekapazität des ersten Energiespeichers 103 und des weiteren Energiespeichers 105, während die Spannung der Parallelschaltung 200 der Spannung der einzelnen Energiespeicher entspricht. Die resultierende Parallelschaltung 200 der Energiespeicher in Fig. 2 weist eine Spannung von 12 V und eine Ladekapazität von 150 Ah auf. Auf diese Art und Weise kann eine Parallelschaltung 200 aus einer beliebigen Anzahl von einzelnen Energiespeichern mit jeweils gleicher Spannung geschaffen werden, wobei die resultierende Spannung der Parallelschaltung 200 der Spannungen der einzelnen Energiespeicher und die Ladekapazität der Parallelschaltung 200 der Summe der Ladekapazitäten der einzelnen Energiespeicher entspricht. Gemäß einer weiteren Ausführungsform kann es sich bei dem ersten Energiespeicher 103 und dem weiteren Energiespeicher 105 um Lithium-Ionen-Akkumulatoren, Lithium-Polymer-Akkumulatoren oder Bleiakkumulatoren handeln.

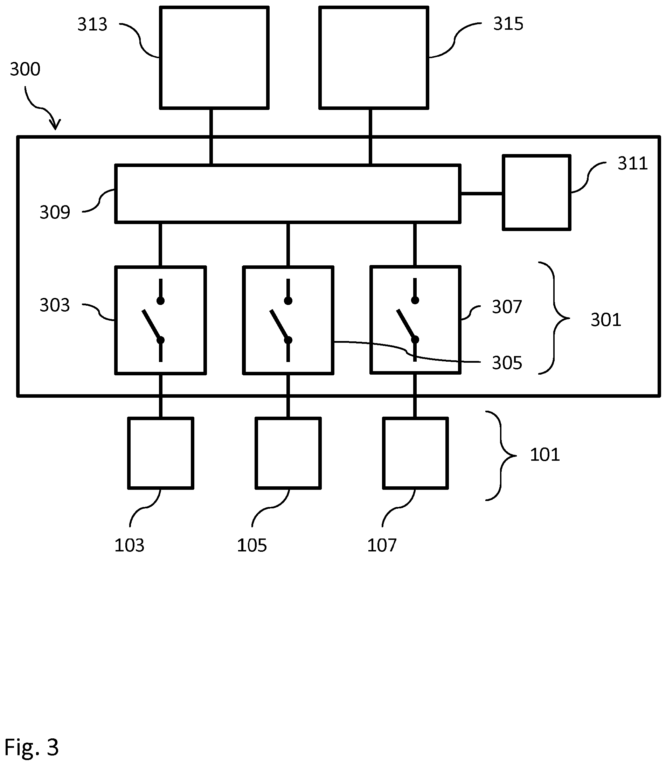

Fig. 3 zeigt eine schematische Darstellung einer Messanordnung 300. Die Messanordnung 300 weist eine Messeinrichtung 309, eine Schaltungsanordnung 301 und eine Prozessoreinrichtung 311 auf, wobei an die Messanordnung 300 eine Energiespeicheranordnung 101, eine Hilfsenergieversorgungsvorrichtung 313 und ein externer Lader 315 angeschlossen sind. Die Schaltungsanordnung 301 umfasst einem ersten steuerbaren Schalter 303 und zwei weitere steuerbare Schalter 305, 307, an welche ein erster Energiespeicher 103 und zwei weitere Energiespeicher 105, 107 angeschlossen sind.

Die Messanordnung 300 zum Erkennen einer Fehlfunktion der Energiespeicheranordnung 101 mit dem ersten Energiespeicher 103 und mit zumindest einem weiteren Energiespeicher 105, 107, wobei der erste Energiespeicher 103 und der weitere Energiespeicher 105, 107 elektrisch parallel geschaltet sind, umfasst die Messeinrichtung 309, welche ausgebildet ist, eine Polarität der elektrischen Messgröße des ersten Energiespeichers 103 und die Polarität der weiteren elektrischen Messgröße in der Energiespeicheranordnung 101 zu erfassen; und die Prozessoreinrichtung 311, welche ausgebildet ist, die Fehlfunktion der Energiespeicheranordnung 101 durch einen Vergleich der Polarität der elektrischen Messgröße des ersten Energiespeichers 103 und der Polarität der weiteren elektrischen Messgröße zu erkennen.

Die Messanordnung 300 kann als abgeschlossenes Modul vorliegen, welches beispielsweise ein Gehäuse umfasst, in dem alle Komponenten der Messanordnung 300 angeordnet sind. Dieses Modul kann elektrische Anschlüsse für eine externe Energiespeicheranordnung 101 vorsehen. Ferner kann die Messanordnung 300 zusammen mit der Energiespeicheranordnung 101 ein abgeschlossenes Bauteil bilden, in welchem beispielsweise die Komponenten der Messanordnung 300 und die Energiespeicheranordnung 101 in einem gemeinsamen Gehäuse angeordnet sind.

Die Prozessoreinrichtung 311 kann ein Mikrocontroller sein, wobei der Mikrocontroller einen Prozessor und/oder einen Speicher umfassen kann. Die Prozessoreinrichtung 311 kann mit der Messeinrichtung 309 zum Empfang der gemessenen elektrischen Messgrößen elektrisch verbunden sein. Ferner kann die Prozessoreinrichtung 311 derart konfiguriert sein, dass sie Parameterwerte aus den empfangenen elektrischen Messgrößen berechnet.

Gemäß einer weiteren Ausführungsform sind die steuerbaren Schalter der Schaltungsanordnung 301 Transistorschalter, insbesondere MOSFET-Schalter. Insbesondere kann jeder steuerbare Schalter aus einer elektrischen Schaltung bestehen, welche zwei in Reihe geschaltete MOSFET-Schalter umfasst, deren Source-Anschlüsse elektrisch verbunden sind. Zusätzlich kann zur Spannungsbegrenzung eine Zener-Diode zwischen die Source- und die Gate-Anschlüsse der MOSFET-Schalter geschalten werden.

Gemäß einer weiteren Ausführungsform kann die Prozessoreinrichtung 311 zur Steuerung der steuerbaren Schalter mit den Gate-Elektroden der Transistorschalter elektrisch verbunden sein und diese durch das Anlegen einer Gate-Spannung elektrisch steuern. Um bei der Ansteuerung der Gate-Elektroden der Transistorschalter eine ausreichend hohen Gate-Spannung bereitzustellen können Gleichspannungswandler, beispielsweise Hochsetzsteller oder Ladungspumpen zwischen die Prozessoreinrichtung 311 und die Gate-Elektroden der Transistorschalter geschaltet sein.

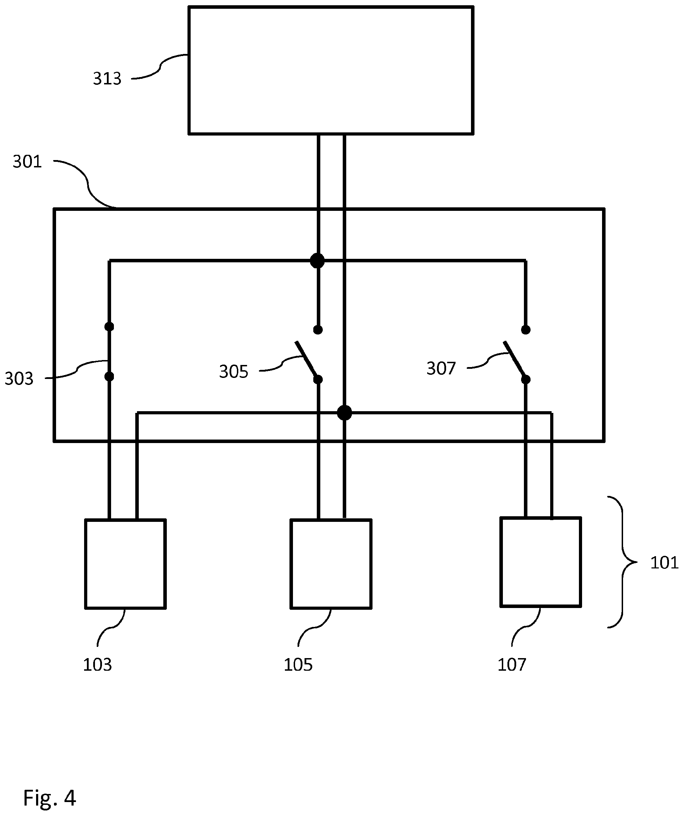

Fig. 4 zeigt eine schematische Darstellung einer Schaltungsanordnung 301 bestehend aus einem ersten steuerbaren Schalter 303 und zwei weiteren steuerbaren Schaltern 305, 307, an welche eine Energiespeicheranordnung 101 bestehend aus einem ersten Energiespeicher 103 und zwei weiteren Energiespeichern 105, 107 angeschlossen ist.

Ferner ist eine Hilfsenergieversorgungsvorrichtung 313 an die Schaltungsanordnung 301 angeschlossen.

Der erste steuerbare Schalter 303 oder die weiteren steuerbaren Schalter 305, 307 der Schaltungsanordnung 301 können geöffnet werden um die Verbindung des ersten Energiespeichers 103 oder der weiteren Energiespeicher 105, 107 mit der Hilfsenergieversorgungsvorrichtung 313 und/oder der Messeinrichtung 309 zu unterbrechen. In Fig. 4 ist der erste steuerbare Schalter 303 geschlossen und sind die weiteren steuerbaren Schalter 305, 307 geöffnet. Die Messeinrichtung 309 und die Prozessoreinrichtung 311 sind in Fig. 3 nicht eingezeichnet.

Gemäß einer weiteren Ausführungsform kann durch die steuerbaren Schalter eine Abschaltmöglichkeit von defekten Energiespeichern der Energiespeicheranordnung 101 geschaffen werden. Bei der Feststellung eines fehlerhaften Energiespeichers kann der mit dem fehlerhaften Energiespeicher verbundene steuerbare Schalter dauerhaft geöffnet werden, und somit die Verbindung des fehlerhaften Energiespeichers mit der Hilfsenergieversorgungsvorrichtung 313 und/oder der Messanordnung 309 und/oder den restlichen Energiespeichern der Energiespeicheranordnung 101 dauerhaft unterbrochen werden. Durch das Abschalten eines fehlerhaften Energiespeichers kann eine negative Beeinflussung der restlichen Energiespeicher, beispielsweise eine Entladung der restlichen Energiespeicher durch den fehlerhaften Energiespeicher, vermieden werden.

Gemäß einer weiteren Ausführungsform kann eine zyklische Prüfung der einzelnen Energiespeicher 103, 105, 107 der Energiespeicheranordnung 101 erfolgen. Diese zyklische Prüfung kann in zeitlich aufeinanderfolgenden Messintervallen erfolgen, wobei in jedem Messintervall ein steuerbarer Schalter, welcher mit einem zu prüfenden Energiespeicher verbunden ist, geschlossen wird und alle anderen steuerbaren Schalter der Schaltungsanordnung 301 geöffnet werden. Somit kann in dem Messintervall die elektrische Messgröße des zu prüfenden Energiespeichers unbeeinflusst von den restlichen Energiespeichern der Energiespeicheranordnung 101 erfolgen. Fig. 4 zeigt beispielsweise die Stellung der Schalter in einem Messintervall, in dem der erste Energiespeicher 103 geprüft wird und zu diesem Zweck nur der erste steuerbare Schalter 303 geschlossen ist und die weiteren steuerbaren Schalter 305, 307 geöffnet sind. Gemäß einer weiteren Ausführungsform kann diese zyklische Prüfung der Energiespeicher in zeitlich aufeinanderfolgenden Messintervallen in einem Testmodus der Messanordnung 300 erfolgen, welcher sich von dem Betriebsmodus, in dem alle steuerbaren Schalter geschlossen sind, unterscheidet.

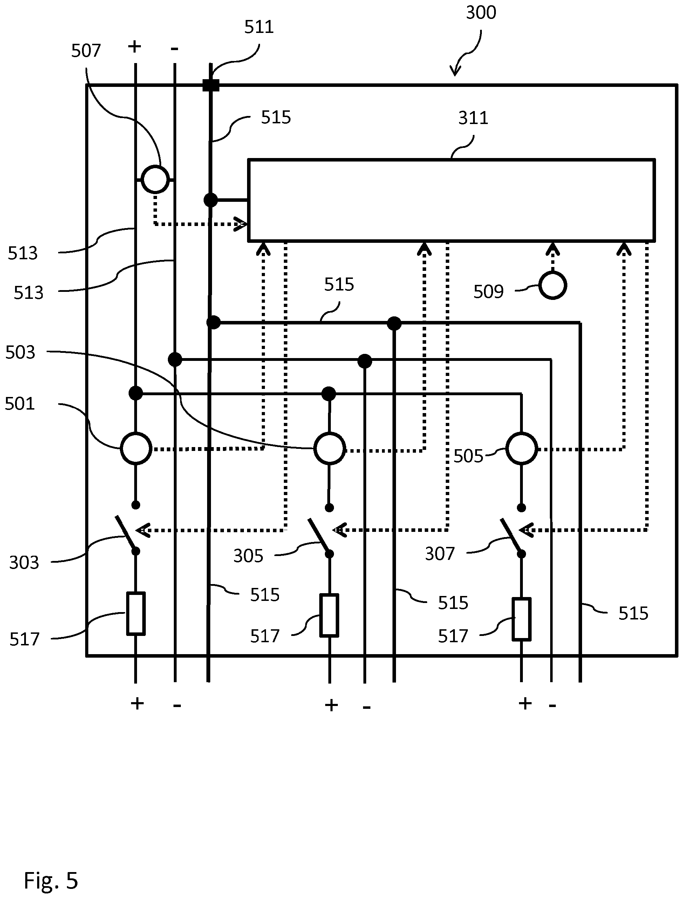

Fig. 5 zeigt eine schematische Darstellung einer Messanordnung 300, wobei einzelne Messeinheiten der Messeinrichtung 309 dargestellt sind. Bei den Messeinheiten handelt es sich um eine mit dem ersten steuerbaren Schalter 303 verbundene erste Messeinheit 501, zwei weiteren Messeinheiten 503, 505, welche jeweils mit einem weiteren steuerbaren Schalter 305, 307 verbunden sind, sowie eine gemeinsame Messeinheit 507 und eine Umgebungsmesseinheit 509. Ferner weist die Messordnung 300 eine elektrische Leitungsanordnung 513 auf, welche die Energiespeicher in der Messanordnung 300 parallel schalten, und eine Kommunikationsleitung 515, welche an die Energiespeicher, die Prozessoreinrichtung 311 und an eine Kommunikationsschnittstelle 511 angeschlossen ist.

Die erste Messeinheit 501 und die weiteren Messeinheiten 503, 505 können eine elektrische Messgröße des ersten Energiespeichers 103, beziehungsweise eine elektrische Messgröße der weiteren Energiespeicher 105, 107 erfassen. Bei diesen elektrischen Messgrößen kann es sich um einen Innenwiderstande, einer Spannung, oder einen Strom handeln. Gemäß einer Ausführungsform können die elektrischen Messgrößen Lade- oder Entladeströme des ersten Energiespeichers 103 und der weiteren Energiespeicher 105, 107 sein, wobei die Stromrichtung die Polarität der elektrischen Messgrößen angibt. Die gemeinsame Messeinheit 507 kann eine gemeinsame elektrische Messgröße des ersten und der weiteren Energiespeicher erfassen. Bei der gemeinsamen elektrischen Messgröße kann es sich ebenfalls um einen Innenwiderstandes, eine Spannung, oder einen Strom handeln. Ferner kann die gemeinsame elektrische Messgröße ein gemeinsamer Lade- oder Entladestrom des ersten Energiespeichers 103 und der weiteren Energiespeicher 105, 107 sein, wobei die Stromrichtung die gemeinsame Polarität der gemeinsamen elektrischen Messgröße angibt.

Gemäß einer weiteren Ausführungsform sind die erste Messeinheit 501, die weiteren Messeinheiten 503, 505 und die gemeinsame Messeinheit 507 an der Prozessoreinrichtung 311 elektrisch angeschlossen. Die in den Messeinheiten ermittelten elektrischen Messgrößen können so an die Prozessoreinrichtung 311 übermittelt und in der Prozessoreinrichtung 311 ausgewertet werden. Diese Auswertung kann aus einem Vergleich der elektrischen Messgrößen untereinander oder einen Vergleich der elektrischen Messgrößen mit elektrischen Referenzgrößen bestehen. Gemäß einer weiteren Ausführungsform ist die Umgebungsmesseinheit 509 eine Temperaturmesseinheit, welche ebenfalls an die Prozessoreinrichtung 311 elektrisch angeschlossen ist. Die gemessenen Temperaturwerte können in der Prozessoreinrichtung 311 ausgewertet werden. Beispielsweise kann bei einem starken Anstieg der Temperatur auf einen defekten Energiespeicher geschlossen werden.

Gemäß einer weiteren Ausführungsform ist an die Kommunikationsschnittstelle 511 eine Kommunikationsleitung 515 angeschlossen. Diese Kommunikationsleitung 515 verbindet die Kommunikationsschnittstelle 511 mit der Prozessoreinrichtung 311 und/oder den Energiespeichern der Energiespeicheranordnung 101. Ist an die Kommunikationsschnittstelle 511 ferner eine Vorrichtung, beispielsweise eine Hilfsenergieversorgungsvorrichtung 313, angeschlossen, so können Parameterwerte und Messgrößen von der Prozessoreinrichtung 311 oder den Energiespeichern 103, 105, 107 an die angeschlossene Vorrichtung übermittelt werden, oder Befehle, beispielsweise Steuerbefehle zum Öffnen oder Schließen der steuerbaren Schalter, von der angeschlossenen Vorrichtung an die Prozessoreinrichtung 311 übermittelt werden.

Gemäß einer weiteren Ausführungsform ist die Kommunikationsschnittstelle 511 eine LIN-Bus Schnittstelle und erflogt die Kommunikation über die Kommunikationsleitung 515 gemäß einem LIN-Bus-Standard. In diesem LIN-Bus-System kann die Hilfsenergieversorgungsvorrichtung 313 als Master und können die Prozessoreinrichtung 311 sowie die Energiespeicher als Slaves eingerichtet sein. Zur Kommunikation über den LIN-Bus kann jeder an die Kommunikationsleitung 515 angeschlossenen Komponente eine eindeutige Kommunikationsadresse zugeordnet sein.

Gemäß einer weiteren Ausführungsform sind die steuerbaren Schalter 303, 305, 307 der Schaltungsanordnung 301 über elektrische Widerstände 517 mit den Energiespeichern 103, 105, 107 der Energiespeicheranordnung 101 elektrisch verbunden. Diese elektrischen Widerstände 517 können bei der Messung der Innenwiderstandes oder der Ladebeziehungsweise Entladeströme der Energiespeicher 103, 105, 107 verwendet werden.

Alle in Verbindung mit einzelnen Ausführungsformen der Erfindung erläuterten und gezeigten Merkmale können in unterschiedlicher Kombination in dem erfindungsgemäßen Gegenstand vorgesehen sein, um gleichzeitig deren vorteilhafte Wirkungen zu realisieren.

### BEZUGSZEICHENLISTE

- 101: Energiespeicheranordnung
- 103: erster Energiespeicher
- 105: weiterer Energiespeicher
- 107: weiterer Energiespeicher
- 109: gemeinsame Stromrichtung der Energiespeicheranordnung
- 111: Stromrichtung des ersten Energiespeichers
- 113: Stromrichtung eines weiteren Energiespeichers
- 115: Stromrichtung eines weiteren Energiespeichers
- 117: Verbindungspunkt

- 200: Parallelschaltung

- 300: Messanordnung
- 301: Schaltungsanordnung
- 303: erster steuerbarer Schalter
- 305: weiterer steuerbarer Schalter
- 307: weiterer steuerbarer Schalter
- 309: Messeinrichtung
- 311: Prozessoreinrichtung
- 313: Hilfsenergieversorgungsvorrichtung
- 315: externer Lader

- 501: erste Messeinheit
- 503: weitere Messeinheit
- 505: weitere Messeinheit
- 507: gemeinsame Messeinheit
- 509: Umgebungsmesseinheit
- 511: Kommunikationsschnittstelle
- 513: elektrische Leitungsanordnung
- 515: Kommunikationsleitung
- 517: elektrischer Widerstand

## Patentansprüche

1. Messanordnung (300) zum Erkennen einer Fehlfunktion einer Energiespeicheranordnung (101) mit einem ersten Energiespeicher (103) und mit zumindest einem weiteren Energiespeicher (105, 107), wobei der erste Energiespeicher (103) und der weitere Energiespeicher (105, 107) elektrisch parallel geschaltet sind,
umfassend eine Messeinrichtung (309), welche ausgebildet ist, eine Polarität eines elektrischen Stroms und/oder Spannung des ersten Energiespeichers (103) und eine Polarität eines weiteren elektrischen Stroms und/oder Spannung in der Energiespeicheranordnung (101) zu erfassen;
eine Prozessoreinrichtung (311), welche ausgebildet ist, die Fehlfunktion der Energiespeicheranordnung (101) durch einen Vergleich der Polarität des elektrischen Stroms und/oder Spannung des ersten Energiespeichers (103) und der Polarität des weiteren elektrischen Stroms und/oder Spannung zu erkennen,
**dadurch gekennzeichnet, dass** die Messanordnung (300) eine Schaltungsanordnung (301) mit einem ersten steuerbaren Schalter (303) zum elektrischen Verbinden des ersten Energiespeichers (103) mit der Messeinrichtung (309), und mit einem weiteren steuerbaren Schalter (305, 307) zum elektrischen Verbinden des weiteren Energiespeichers (105, 107) mit der Messeinrichtung (309) aufweist, um den ersten Energiespeicher (103) und den weiteren Energiespeicher (105, 107) parallel zu schalten, wobei die Prozessoreinrichtung (311) ausgebildet ist, zur Erfassung der Polarität des elektrischen Stroms und/oder Spannung des ersten Energiespeichers (103) und zur Erfassung der Polarität des weiteren elektrischen Stroms und/oder Spannung den ersten Schalter (303) und den weiteren Schalter (305, 307) zu schließen oder geschlossen zu halten, und
wobei die Prozessoreinrichtung (311) ausgebildet ist, die gemessenen elektrischen Ströme und/oder Spannungen auszuwerten, insbesondere mit elektrischen Referenzgrößen zu vergleichen, um eine Fehlfunktion des ersten Energiespeichers (103) oder des weiteren Energiespeichers (105, 107) zu erfassen.

2. Messanordnung (300) nach Anspruch 1, wobei die Prozessoreinrichtung (311) ausgebildet ist, die Fehlfunktion der Energiespeicheranordnung (101) zu erkennen, falls die Polarität des elektrischen Stroms und/oder Spannung des ersten Energiespeichers (103) und die Polarität des weiteren elektrischen Stroms und/oder Spannung unterschiedlich sind.

3. Messanordnung (300) nach Anspruch 1 oder 2, wobei die Messeinrichtung (309) ausgebildet ist, die Polarität des elektrischen Stroms und/oder Spannung des ersten Energiespeichers (103) und die Polarität des weiteren elektrischen Stroms und/oder Spannung durch Erfassung einer elektrischen Richtung des elektrischen Stroms und/oder Spannung des ersten Energiespeichers (103) und des weiteren elektrischen Stroms und/oder Spannung zu erfassen.

4. Messanordnung (300) nach einem der vorstehenden Ansprüche, wobei der weitere elektrische Strom und/oder Spannung ein elektrischer Strom und/oder Spannung des weiteren Energiespeichers (105, 107) ist, oder wobei der weitere elektrische Strom und/oder Spannung ein elektrischer Strom und/oder Spannung an einem Verbindungspunkt (117) des ersten Energiespeichers (103) und des weiteren Energiespeichers (105, 107) ist.

5. Messanordnung (300) nach einem der vorstehenden Ansprüche, welche eine erste Messeinheit (501) zur Erfassung der Polarität des elektrischen Stroms und/oder Spannung des ersten Energiespeichers (103) und eine weitere Messeinheit (503, 505) zur Erfassung der Polarität des weiteren elektrischen Stroms und/oder Spannung aufweist.

6. Messanordnung (300) nach Anspruch 5, wobei die erste Messeinheit (501) ausgebildet ist, die Polarität des elektrischen Stroms und/oder Spannung des ersten Energiespeichers (103) zu erfassen, und wobei die weitere Messeinheit (503, 505) ausgebildet ist, die Polarität des elektrischen Stroms und/oder Spannung des weiteren Energiespeichers (105, 107) zu erfassen, oder wobei die weitere Messeinheit (503, 505) ausgebildet ist, die Polarität des weiteren elektrischen Stroms und/oder Spannung an einem Verbindungspunkt (117) des ersten Energiespeichers (103) und des weiteren Energiespeichers (105, 107) zu erfassen.

7. Messanordnung (300) nach Anspruch 5 oder 6, wobei die weitere Messeinheit (503, 505) ausgebildet ist, die Polarität des elektrischen Stroms und/oder Spannung des weiteren Energiespeichers (105, 107) zu erfassen, wobei die Messeinrichtung (309) eine gemeinsame Messeinheit (507) zur Erfassung der Polarität des elektrischen Stroms und/oder Spannung an dem Verbindungspunkt (117) des ersten Energiespeichers (103) und des weiteren Energiespeichers (105, 107) aufweist, um eine gemeinsame Polarität zu erhalten, und wobei die Prozessoreinrichtung (311) ausgebildet ist, die Fehlfunktion der Energiespeicheranordnung durch einen Vergleich der Polarität des elektrischen Stroms und/oder Spannung des ersten Energiespeichers (103) oder der Polarität des weiteren elektrischen Stroms und/oder Spannung mit der gemeinsamen Polarität zu erkennen.

8. Messanordnung (300) nach einem der vorstehenden Ansprüche, wobei
die Prozessoreinrichtung (311) ausgebildet ist, zur Erfassung des ersten elektrischen Stroms und/oder Spannung des ersten elektrischen Energiespeichers (103) den ersten Schalter (303) geschlossen zu halten und den weiteren Schalter (305, 307) zu öffnen, um den weiteren elektrischen Energiespeicher (105, 107) von der Messeinrichtung (309) abzutrennen, und zur Erfassung des weiteren elektrischen Stroms und/oder Spannung des weiteren elektrischen Energiespeichers (105, 107) den weiteren Schalter (305, 307) geschlossen zu halten und den ersten Schalter (303) zu öffnen, um den ersten Energiespeicher (103) von der Messeinrichtung (309) abzutrennen, und wobei
die Messeinrichtung (309) ausgebildet ist, den ersten elektrischen Strom und/oder Spannung und den weiteren elektrischen Strom und/oder Spannung nacheinander zu messen.

9. Messanordnung (300) nach einem der vorstehenden Ansprüche, wobei die Prozessoreinrichtung (311) ausgebildet ist, die gemessenen elektrischen Ströme und/oder Spannungen auszuwerten, insbesondere mit elektrischen Referenzgrößen zu vergleichen, um eine Fehlfunktion des ersten Energiespeichers (103) oder des weiteren Energiespeichers (105, 107) zu erfassen.

10. Messanordnung (300) nach Anspruch 9, wobei Prozessoreinrichtung (311) ausgebildet ist, bei erfasster Fehlfunktion des ersten Energiespeichers (103) den ersten steuerbaren Schalter (303) dauerhaft zu öffnen, um den ersten Energiespeicher (103) abzutrennen, oder bei erfasster Fehlfunktion des weiteren Energiespeichers (105, 107) den weiteren steuerbaren Schalter (305, 307) dauerhaft zu öffnen, um den weiteren Energiespeicher (105, 107) abzutrennen.

11. Messanordnung (300) nach einem der vorstehenden Ansprüche, wobei die Messanordnung (300) einen Verbindungsanschluss zum Verbinden der Schaltungsanordnung (301) mit einer Hilfsenergieversorgungsvorrichtung (313), insbesondere einer unterbrechungsfreien Spannungsversorgung aufweist, um die elektrischen Energiespeicher für die Hilfsenergieversorgung bereitzustellen.

12. Messanordnung (300) nach einem der vorstehenden Ansprüche, welche den ersten Energiespeicher (103) und den weiteren Energiespeicher (105, 107) umfasst.

13. Hilfsenergieversorgungsvorrichtung (313) zur netzunabhängigen Bereitstellung elektrischer Energie, wobei die Messanordnung (300) nach einem der vorstehenden Ansprüche in der Hilfsenergieversorgungsvorrichtung (313) integriert ist.

## Claims

1. Measuring arrangement (300) for identifying a malfunction of an energy accumulator assembly (101) comprising a first energy accumulator (103) and at least one further energy accumulator (105, 107), wherein the first energy accumulator (103) and the further energy accumulator (105, 107) are electrically connected in parallel, the measuring arrangement (300) comprising:
a measuring device (309) which is configured to capture a polarity of an electric current and/or voltage of the first energy accumulator (103) and a polarity of a further electric current and/or voltage in the energy accumulator assembly (101);
a processor device (311) which is configured to identify the malfunction of the energy accumulator assembly (101) by comparing the polarity of the electric current and/or voltage of the first energy accumulator (103) and the polarity of the further electric current and/or voltage,
**characterized by**,
that the measuring arrangement (300) comprises a circuit arrangement (301) comprising a first controllable switch (303) for electrically connecting the first energy accumulator (103) with the measuring device (309) and a further controllable switch (305, 307) for electrically connecting the further energy accumulator (105, 107) with the measuring device (309) in order to connect the first energy accumulator (103) and the further energy accumulator (105, 107) in parallel, wherein the processor device (311) is configured to close the first switch (303) and the further switch (305, 307) or to keep them closed for capturing the polarity of the electric current and/or voltage of the first energy accumulator (103) and for capturing the polarity of the further electric current and/or voltage, and
wherein the processor device (311) is configured to evaluate the measured electric currents and/or voltages, in particular to compare them with electric reference variables, in order to identify a malfunction of the first energy accumulator (103) or the further energy accumulator (105,107).

2. Measuring arrangement (300) according to claim 1, wherein the processor device (311) is configured to identify the malfunction of the energy accumulator assembly (101) if the polarity of the electric current and/or voltage of the first energy accumulator (103) and the polarity of the further electric current and/or voltage are different.

3. Measuring arrangement (300) according to claim 1 or 2, wherein the measuring device (309) is configured to capture the polarity of the electric current and/or voltage of the first energy accumulator (103) and the polarity of the further electric current and/or voltage by capturing an electric direction of the electric current and/or voltage of the first energy accumulator (103) and of the further electric current and/or voltage.

4. Measuring arrangement (300) according to one of the preceding claims, wherein the further electric current and/or voltage is an electric current and/or voltage of the further energy accumulator (105, 107), or wherein the further electric current and/or voltage is an electric current and/or voltage at a connection point (117) of the first energy accumulator (103) and of the further energy accumulator (105, 107).

5. Measuring arrangement (300) according to one of the preceding claims, which comprises a first measuring unit (501) for capturing the polarity of the electric current and/or voltage of the first energy accumulator (103), and a further measuring unit (503, 505) for capturing the polarity of the further electric current and/or voltage.

6. Measuring arrangement (300) according to claim 5, wherein the first measuring unit (501) is configured to capture the polarity of the electric current and/or voltage of the first energy accumulator (103), and wherein the further measuring unit (503, 505) is configured to capture the polarity of the electric current and/or voltage of the further energy accumulator (105, 107), or wherein the further measuring unit (503, 505) is configured to capture the polarity of the further electric current and/or voltage at a connection point (117) of the first energy accumulator (103) and of the further energy accumulator (105, 107).

7. Measuring arrangement (300) according to claim 5 or 6, wherein the further measuring unit (503, 505) is configured to capture the polarity of the electric current and/or voltage of the further energy accumulator (105, 107), wherein the measuring device (309) comprises a common measuring unit (507) for capturing the polarity of the electric current and/or voltage at the connection point (117) of the first energy accumulator (103) and of the further energy accumulator (105, 107) in order to obtain a common polarity, and wherein the processor device (311) is configured to identify the malfunction of the energy accumulator assembly by comparing the polarity of the electric current and/or voltage of the first energy accumulator (103) or the polarity of the further electric current and/or voltage with the common polarity.

8. Measuring arrangement (300) according to one of the preceding claims,
wherein the processor device (311) is configured, for capturing the first electric current and/or voltage of the first electric energy accumulator (103), to keep the first switch (303) closed and to open the further switch (305, 307) in order to disconnect the further electric energy accumulator (105, 107) from the measuring device (309) and, for capturing the further electric current and/or voltage of the further electric energy accumulator (105, 107), to keep the further switch (305, 307) closed and to open the first switch (303) in order to disconnect the first energy accumulator (103) from the measuring device (309), and wherein
the measuring device (309) is configured to measure the first electric current and/or voltage and the further electric current and/or voltage in succession.

9. Measuring arrangement (300) according to one of the preceding claims, wherein the processor device (311) is configured to evaluate the measured electric currents and/or voltages, in particular to compare them with electric reference variables, in order to identify a malfunction of the first energy accumulator (103) or of the further energy accumulator (105, 107).

10. Measuring arrangement (300) according to claim 9, wherein the processor device (311) is configured to permanently open the first controllable switch (303) if a malfunction of the first energy accumulator (103) is identified in order to disconnect the first energy accumulator (103) or to permanently open the further controllable switch (305, 307) if a malfunction of the further energy accumulator (105, 107) is identified in order to disconnect the further energy accumulator (105, 107).

11. Measuring arrangement (300) according to one of the preceding claims, wherein the measuring arrangement (300) comprises a connection terminal for connecting the circuit arrangement (301) to an auxiliary energy supply apparatus (313), in particular an uninterruptible voltage supply, in order to provide the electric energy accumulators for the auxiliary energy supply.

12. Measuring arrangement (300) according to one of the preceding claims, which comprises the first energy accumulator (103) and the further energy accumulator (105, 107).

13. Auxiliary energy supply apparatus (313) for providing electric energy mains-independently, wherein the measuring arrangement (300) is integrated in the auxiliary energy supply apparatus (313) according to one of the preceding claims.

## Revendications

1. Ensemble de mesure (300) permettant d'identifier un dysfonctionnement d'un ensemble accumulateur d'énergie (101) doté d'un premier accumulateur d'énergie (103) et d'au moins un autre accumulateur d'énergie (105, 107), le premier accumulateur d'énergie (103) et l'autre accumulateur d'énergie (105, 107) étant connectés électriquement en parallèle, comprenant
un dispositif de mesure (309) qui est réalisé pour détecter une polarité d'un courant électrique et/ou d'une tension électrique du premier accumulateur d'énergie (103) et une polarité d'un autre courant électrique et/ou d'une autre tension électrique dans l'ensemble accumulateur d'énergie (101) ;
un dispositif processeur (311) qui est réalisé pour identifier le dysfonctionnement de l'ensemble accumulateur d'énergie (101) par une comparaison de la polarité du courant électrique et/ou de la tension électrique du premier accumulateur d'énergie (103) et de la polarité de l'autre courant électrique et/ou de l'autre tension électrique,
**caractérisé en ce que** l'ensemble de mesure (300) présente un ensemble de circuit (301) doté d'un premier commutateur pouvant être commandé (303) pour la connexion électrique du premier accumulateur d'énergie (103) au dispositif de mesure (309), et d'un autre commutateur pouvant être commandé (305, 307) pour la connexion électrique de l'autre accumulateur d'énergie (105, 107) au dispositif de mesure (309) afin de connecter en parallèle le premier accumulateur d'énergie (103) et l'autre accumulateur d'énergie (105, 107), le dispositif processeur (311) étant réalisé, en vue de la détection de la polarité du courant électrique et/ou de la tension électrique du premier accumulateur d'énergie (103) et de la détection de la polarité de l'autre courant électrique et/ou de l'autre tension électrique, pour fermer ou maintenir fermés le premier commutateur (303) et l'autre commutateur (305, 307), et
le dispositif processeur (311) étant réalisé pour évaluer les courants et/ou tensions électriques mesurés, en particulier pour les comparer à des grandeurs de référence électriques afin de détecter un dysfonctionnement du premier accumulateur d'énergie (103) ou de l'autre accumulateur d'énergie (105, 107).

2. Ensemble de mesure (300) selon la revendication 1, le dispositif processeur (311) étant réalisé pour identifier le dysfonctionnement de l'ensemble accumulateur d'énergie (101) si la polarité du courant électrique et/ou de la tension électrique du premier accumulateur d'énergie (103) et la polarité de l'autre courant électrique et/ou de l'autre tension électrique sont différentes.

3. Ensemble de mesure (300) selon la revendication 1 ou 2, le dispositif de mesure (309) étant réalisé pour détecter la polarité du courant électrique et/ou de la tension électrique du premier accumulateur d'énergie (103) et la polarité de l'autre courant électrique et/ou de l'autre tension électrique en détectant un sens électrique du courant électrique et/ou de la tension électrique du premier accumulateur d'énergie (103) et de l'autre courant électrique et/ou de l'autre tension électrique.

4. Ensemble de mesure (300) selon l'une quelconque des revendications précédentes, dans lequel l'autre courant électrique et/ou l'autre tension électrique est un courant électrique et/ou une tension électrique de l'autre accumulateur d'énergie (105, 107), ou dans lequel l'autre courant électrique et/ou l'autre tension électrique est un courant électrique et/ou une tension électrique au niveau d'un point de jonction (117) du premier accumulateur d'énergie (103) et de l'autre accumulateur d'énergie (105, 107).

5. Ensemble de mesure (300) selon l'une quelconque des revendications précédentes qui présente une première unité de mesure (501) pour détecter la polarité du courant électrique et/ou de la tension électrique du premier accumulateur d'énergie (103) et une autre unité de mesure (503, 505) pour détecter la polarité de l'autre courant électrique et/ou de l'autre tension électrique.

6. Ensemble de mesure (300) selon la revendication 5, la première unité de mesure (501) étant réalisée pour détecter la polarité du courant électrique et/ou de la tension électrique du premier accumulateur d'énergie (103), et l'autre unité de mesure (503, 505) étant réalisée pour détecter la polarité du courant électrique et/ou de la tension électrique de l'autre accumulateur d'énergie (105, 107), ou l'autre unité de mesure (503, 505) étant réalisée pour détecter la polarité de l'autre courant électrique et/ou de l'autre tension électrique au niveau d'un point de jonction (117) du premier accumulateur d'énergie (103) et de l'autre accumulateur d'énergie (105, 107).

7. Ensemble de mesure (300) selon la revendication 5 ou 6, l'autre unité de mesure (503, 505) étant réalisée pour détecter la polarité du courant électrique et/ou de la tension électrique de l'autre accumulateur d'énergie (105, 107), le dispositif de mesure (309) présentant une unité de mesure (507) commune pour détecter la polarité du courant électrique et/ou de la tension électrique au niveau du point de jonction (117) du premier accumulateur d'énergie (103) et de l'autre accumulateur d'énergie (105, 107) afin d'obtenir une polarité commune, et le dispositif processeur (311) étant réalisé pour identifier le dysfonctionnement de l'ensemble accumulateur d'énergie par une comparaison de la polarité du courant électrique et/ou de la tension électrique du premier accumulateur d'énergie (103) ou de la polarité de l'autre courant électrique et/ou de l'autre tension électrique avec la polarité commune.

8. Ensemble de mesure (300) selon l'une quelconque des revendications précédentes, le dispositif processeur (311) étant réalisé, en vue de la détection du premier courant électrique et/ou de la première tension électrique du premier accumulateur d'énergie électrique (103), pour maintenir fermé le premier commutateur (303) et pour ouvrir l'autre commutateur (305, 307) afin de séparer l'autre accumulateur d'énergie électrique (105, 107) du dispositif de mesure (309), et en vue de la détection de l'autre courant électrique et/ou de l'autre tension électrique de l'autre accumulateur d'énergie électrique (105, 107), pour maintenir fermé l'autre commutateur (305, 307) et pour ouvrir le premier commutateur (303) afin de séparer le premier accumulateur d'énergie (103) du dispositif de mesure (309), et le dispositif de mesure (309) étant réalisé pour mesurer les uns après les autres le premier courant électrique et/ou la première tension électrique et l'autre courant électrique et/ou l'autre tension électrique.

9. Ensemble de mesure (300) selon l'une quelconque des revendications précédentes, le dispositif processeur (311) étant réalisé pour évaluer les courants et/ou tensions électriques mesurés, en particulier pour les comparer avec des grandeurs de référence électriques afin de détecter un dysfonctionnement du premier accumulateur d'énergie (103) ou de l'autre accumulateur d'énergie (105, 107).

10. Ensemble de mesure (300) selon la revendication 9, le dispositif processeur (311) étant réalisé, lorsqu'un dysfonctionnement du premier accumulateur d'énergie (103) a été détecté, pour ouvrir de façon permanente le premier commutateur pouvant être commandé (303) afin de séparer le premier accumulateur d'énergie (103), ou lorsqu'un dysfonctionnement de l'autre accumulateur d'énergie (105, 107) a été détecté, pour ouvrir de façon permanente l'autre commutateur pouvant être commandé (305, 307) afin de séparer l'autre accumulateur d'énergie (105, 107).

11. Ensemble de mesure (300) selon l'une quelconque des revendications précédentes, l'ensemble de mesure (300) présentant une borne de connexion pour connecter l'ensemble de circuit (301) à un dispositif d'alimentation en énergie auxiliaire (313), en particulier à une alimentation en tension sans interruption afin de fournir les accumulateurs d'énergie électriques pour l'alimentation en énergie auxiliaire.

12. Ensemble de mesure (300) selon l'une quelconque des revendications précédentes, présentant le premier accumulateur d'énergie (103) et l'autre accumulateur d'énergie (105, 107).

13. Dispositif d'alimentation en énergie auxiliaire (313) pour la fourniture indépendante du secteur d'énergie électrique, l'ensemble de mesure (300) selon l'une quelconque des revendications précédentes étant intégré dans le dispositif d'alimentation en énergie auxiliaire (313).
